# EUROPEAN PATENT APPLICATION

(11) **EP 0 706 206 A2**
(43) Date of publication of application: **10.04.1996**
(21) Application number: 95114230.6
(22) Date of filing: 11.09.1995
(51) Int. Cl.: H01L 21/311

(54) **Method for etching silicon nitride**

(30) Priority: 19.09.1994 US 308224
(71) Applicant: MOTOROLA, INC., Schaumburg, IL 60196 (US)
(72) Inventor: Lin, Jung-Hui, Austin, Texas 78750 (US); Koh, Ai, Austin, Texas 78729 (US)
(74) Representative: Hirsz, Christopher Stanislaw

(57) **Abstract**

In accordance with the present invention, a silicon nitride layer (20) in a semiconductor device (10) is anisotropically etched selectively to both silicon dioxide, for example gate oxide layer (16), and to silicon, for example, silicon substrate (12) and polysilicon gate electrode (18). The silicon nitride layer is etched in a plasma etch system using CF₄, O₂, and argon gases. In other applications of the present invention, the etch method is used to remove an ONO dielectric stack and to remove a silicon nitride etch stop layer selectively to both active regions and isolation regions to form contacts or local interconnects across these regions.

## Description

### Field of the Invention

The present invention relates generally to methods for etching silicon nitride, and more specifically to methods for etching silicon nitride films in semiconductor devices.

### Background of the Invention

Silicon nitride is used in semiconductor devices for a variety of reasons, including use as etch stop layers, masking layers, sidewall spacers, gate dielectrics, and the like. Because silicon nitride is used so heavily in the manufacture of semiconductor devices, a variety of etch chemistries are necessary in order to remove the silicon nitride from selective areas of the device. In removing silicon nitride, it is often necessary to etch the silicon nitride away without damaging or etching underlying layers within the semiconductor device. For example, it is often necessary to remove silicon nitride selectively to an underlying layer of silicon dioxide, or to an underlying polysilicon layer, or to the silicon substrate. A variety of dry etch chemistries exist which accomplish these objectives. For example, a common dry etch which is used to etch silicon nitride selectively to silicon dioxide uses SF₆. As another example, a chemistry of CHF₃ and O₂ is used to dry etch silicon nitride selectively to silicon. As is evident from these examples, different dry etch chemistries are often required to etch silicon nitride selectively to silicon dioxide and silicon. To date, no dry etch chemistry has been developed which can etch silicon nitride selectively to both silicon dioxide and to silicon simultaneously with acceptable selectivity values. A dry silicon nitride etch having selectivity to both silicon dioxide and silicon would be a welcome advance in the field of semiconductor manufacturing, particularly in areas such as local interconnect and sidewall spacer technology.

### Brief Description of the Drawings

FIGs. 1-3 are cross-sectional illustrations of a portion of a semiconductor device wherein sidewall spacers are formed in accordance with the present invention.

FIGs. 4-6 are cross-sectional illustrations of a portion of a semiconductor device wherein the present invention is used for the manufacture of a device which includes an ONO (oxide-nitride-oxide) gate dielectric stack.

FIGs. 7-9 are cross-sectional illustrations of a portion of a semiconductor device wherein a local interconnect is formed in accordance with the present invention.

### Detailed Description of a Preferred Embodiment

In accordance with the present invention silicon nitride can be dry etched selectively to both silicon dioxide and silicon. Etching is accomplished in a plasma etch system and is anisotropic in nature. The selectivity and anisotropic nature of the etch is achieved through the use of CF₄ and O₂ gases with the addition of an inert gas, such as argon. While CF₄, O₂ and argon may be known individually for use in etching materials in semiconductor manufacturing, a combination of these gases in accordance with the present invention can achieve results not accomplished with prior art methods. For example, in prior art methods use of these gases to etch silicon nitride could not be achieved anisotropically, nor could the gases in combination be used to etch silicon nitride selectively to both silicon dioxide and silicon.

A preferred embodiment of the present invention employs a plasma etch system which does not generate a plasma downstream from the material to be etched, rather a plasma is generated within the etch chamber where the device to be etched is located. As an example, a magnetron etcher, such as Applied Materials' AMT5000, is a suitable etch system for practicing the present invention. Specific process parameters may vary depending on the type of plasma etch system used; however, the following process parameters have been demonstrated as providing the foregoing characteristics in the magnetron etch system. A pressure of the etch chamber is held to between 50-300 mTorr, while the RF power is held between 100-300 Watts. A CF₄ gas is introduced into the etch chamber at a rate of 2-8 standard cubic centimeters per minute (sccm). The flow rate of oxygen is 5-35 sccm, while the flow rate of an inert gas is between 40-140 sccm. While in a preferred embodiment argon is used as the inert gas, it is anticipated that other inert gases can be used, for example, xenon, helium, or nitrogen. With the foregoing process parameters, the selectivity of a plasma-enhanced chemical vapor deposited (PECVD) silicon nitride film etched selectively to oxide ranges from 1.5:1 to 9:1, with 33 out of 35 combinations achieving a selectivity greater than 2:1. Also with the foregoing process parameters, the selectivity of etching a PECVD silicon nitride film selectively to polysilicon ranges from 2.3:1 to 17:1, with 34 out of 35 combinations achieving a selectivity greater than 2.5:1.

Within the above process parameter ranges, the mechanism for etching silicon nitride in accordance with the invention involves both a chemical aspect and a physical bombardment or sputtering component, as opposed to being purely chemical mechanism. Thus, the etch may be classified as a reactive ion etch (RIE). The physical etch mechanism can be attributed to the facts that the etch system used is not a downstream etcher, that the pressure is maintained relatively low, that the silicon nitride is etched anisotropically, and that the ion energy within the etch chamber is relatively high (about 200 Volts).

While various combinations within the process parameter ranges provided above can successfully be used to etch silicon nitride selectively to both silicon dioxide and silicon, more preferred process parameter ranges are as follows: etch chamber pressure of 150-300 mTorr; RF Power between 100-300 Watts; CF₄ flow rate of 2-8 sccm; O₂ flow of 20-35 sccm, and inert (argon) flow rate of 40-140 sccm. Selectivity of silicon nitride to oxide within the preferred process parameter ranges is about 6:1 to 10:1, while selectivity of silicon nitride to silicon is about 12:1 to 17:1. A precise set of process parameters as used in the magnetron etch system which achieves a selectivity of silicon nitride to oxide of 8:1 and a selectivity of silicon nitride to polysilicon of 16:1 is as follows: pressure equal to 150 mTorr; RF power equal to 200 Watts; CF₄ flow rate equal to 3 sccm; O₂ flow rate equal to 30 sccm; and inert gas (argon) flow rate equal to 60 sccm. At all times the magnetic field used in the magnetron etch system was held to 30 gauss; however, it is anticipated that an increase or decrease in the magnetic field would only increase or decrease, respectively, the etch rates without adversely affecting the etch selectivities. Accordingly, the present invention may also achieve acceptable selectivity levels in the absence of any magnetic field. Also, it is noted that the etch selectivities resulting from the above processes occurred in etching silicon nitride in the presence of a photoresist mask, and that etch selectivities without a resist mask in place may be lower due to a lower concentration of polymers within the etch chamber.

Although the precise mechanisms for how the present invention as described above achieves selectivity to both silicon dioxide and silicon and achieves an anisotropic etch are not fully understood, experimentation has led to observation of some trends. The selectivity of silicon nitride to both silicon dioxide and polysilicon increases as the oxygen flow rate is increased within the range specified above (without varying any other process parameters). Varying only the RF Power within the range specified above resulted in an initial increase in both the selectivity to oxide and polysilicon, but then both selectivities begin to decrease as the end of this range is approached. Increasing the CF₄ flow rate without varying other process parameters tends to decrease the selectivity to both oxide and polysilicon. Increasing the flow rate of argon likewise decreased the selectivity to both oxide and polysilicon; however, the rate of decrease is less drastic than the trend observed with the CF₄ flow rate. Finally, increasing the pressure through the range specified above tends to increase the selectivity of etching silicon nitride to both oxide and polysilicon. How selectivities are affected by varying more than one process variable at a time have not been analyzed, so that the interaction of the various process variables is not understood. Further, experiments indicate that selectivities to both silicon dioxide and silicon are optimized within the above specified process parameter ranges when the flow rate of O₂ is at least three , and preferably at least four, times as great as the flow rate of CF₄, and when the inert (argon) gas flow rate is at least fifteen, and preferably at least sixteen, times as great as the flow rate of CF₄.

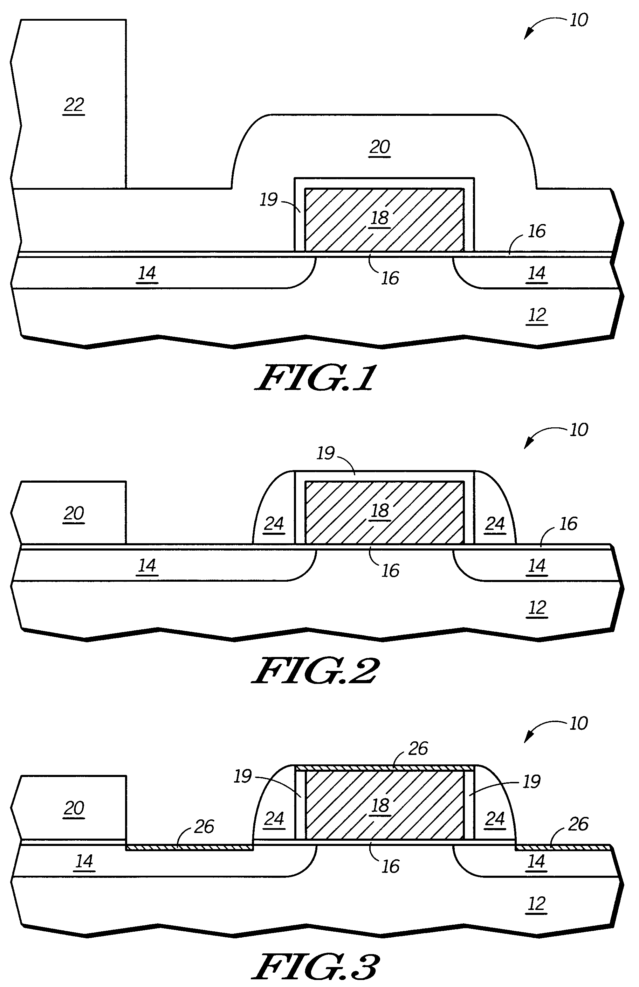

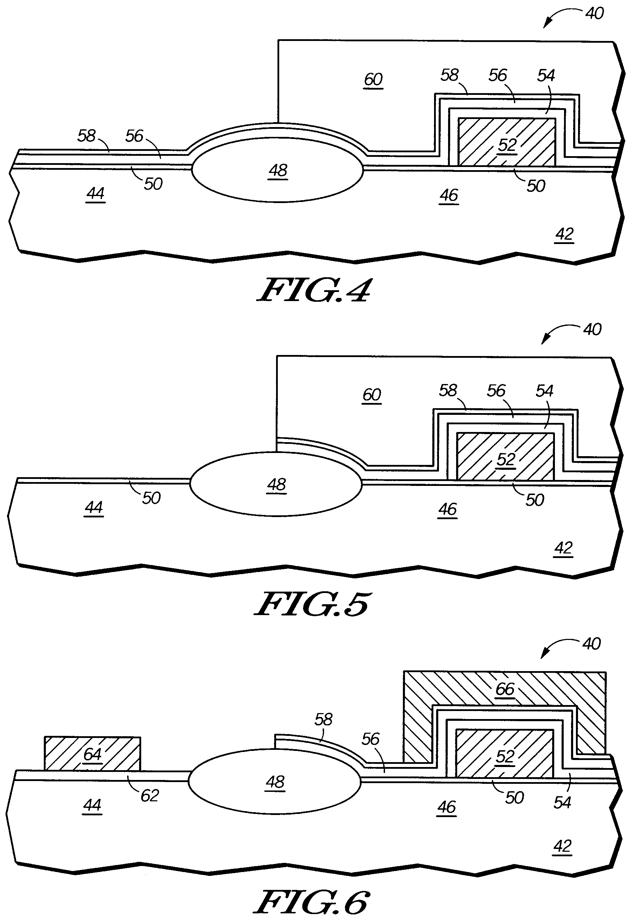

As mentioned earlier, silicon nitride has a variety of uses within the manufacture of semiconductor devices. These applications, and advantages, of the present invention will be more clearly understood from the following detailed description taken in conjunction with the accompanying drawings. FIGs. 1-9 illustrate three examples of applications for use of the present invention in semiconductor manufacturing; however, other applications no doubt exist. It is important to point out that the illustrations may not necessarily be drawn to scale and that there may be other embodiments of the present invention which are not specifically illustrated. Throughout the various views, like reference numerals are used to designate identical or corresponding parts.

FIGs. 1-3 illustrate using the present invention to form silicon nitride sidewall spacers. As shown in FIG. 1, a semiconductor device 10 includes an active region of a semiconductor substrate 12. Within substrate 12 are doped regions 14 which serve as source and drain regions of an MOS (Metal Oxide Semiconductor) transistor. Typically, substrate 12 will be formed of single crystal silicon and doped regions 14 are formed by diffusing or implanting impurity atoms, either P-type or N-type, into the substrate. Overlying substrate 12 is a gate oxide layer 16, which is typically thermally grown to a thickness of less than 300Å. A polysilicon gate electrode 18 is patterned on the gate oxide layer. Gate electrode 18 is aligned such that sides or edges of the gate electrode are closely aligned with doped regions 14, although in actual manufacturing the doped regions are typically formed after the polysilicon gate electrode is patterned and are self-aligned to the gate electrode. After the gate electrode and doped regions have been defined on substrate 12, the polysilicon may be oxidized to form an oxide layer 19 on the gate electrode. A silicon nitride layer 20 is then deposited using conventional chemical vapor deposition (CVD). In accordance with this embodiment of the present invention, silicon nitride layer 20 will be used as a masking layer in a self-aligned silicide process. Silicide is often formed on polysilicon members and doped regions to improve the conductivity between these members and other conductive members within the device, such as contacts. A self-aligned silicide process involves using a mask to protect those regions of the device which are not to be silicided, and wherein the silicidation process can occur without a separate lithography step (i.e. the silicidation is self-aligned).

To achieve the self-aligned silicidation process in device 10 in accordance with the present invention, a resist mask 22, for example a photoresist mask, is formed over the device as illustrated in FIG. 1. Next, silicon nitride layer 20 is anisotropically etched with the resist mask in place using the etch method previously described in accordance with the invention. The resulting structure is illustrated in FIG. 2, wherein portions of silicon nitride layer 20 which were not protected by resist mask 22 in FIG. 1 have been anisotropically etched to form sidewall spacers 24 along sidewalls of polysilicon gate electrode 18 and wherein portions of silicon nitride layer 20 which were protected by resist mask 22 remain intact. Notice that as a result of the etch, gate oxide layer 16 is not attacked, since the etch chemistry used to etch silicon nitride in accordance with the present invention is selective to silicon dioxide. It is desirable to not remove gate oxide layer 16 in order to avoid damaging the underlying substrate when removing the silicon nitride layer by a plasma etch, even though the oxide layer may subsequently be removed.

In prior art methods which have attempted to achieve similar results, a problem known as silicon pitting has arisen. Silicon pitting results from attempting to etch a silicon nitride layer selectively to a thin silicon dioxide layer. Prior art chemistries have the ability to etch silicon nitride selectively to silicon dioxide. An example is the use of SF₆. But many of these chemistries are not selective to silicon, such that if the underlying silicon dioxide layer may be damaged or may include defects, the etch used to etch the silicon nitride selectively to the silicon dioxide will end up etching any underlying silicon or polysilicon members. The present invention overcomes the problem of silicon and polysilicon pitting because even if gate oxide layer 16 or oxide layer 19 is damaged or includes defects, the etch used to etch silicon nitride layer 20 is selective to both silicon dioxide and silicon such that etching silicon nitride layer 20 will not etch any portion of silicon substrate 12 or polysilicon gate electrode 18.

After silicon nitride layer 20 is etched in accordance with the present invention, portions of gate oxide layer 16 and oxide layer 19 which are not protected by either sidewall spacers 24 or remaining portions of silicon nitride layer 20 are then removed with a conventional wet etch to expose portions of doped regions 14 and gate electrode 18, as illustrated in FIG. 3. The exposed portions of doped regions 14, and any exposed polysilicon, undergo a conventional silicidation process. A typical silicidation process involves the deposition of titanium or other refractory metal across the entire device, and thermally reacting the metal with adjacent silicon members to form a refractory metal silicide. An etch is then used to remove unreacted portions of the titanium layer, without removing the reacted titanium silicide. FIG. 3 illustrates silicide regions 26 formed within both doped regions 14 and polysilicon gate electrode 18 in accordance with this embodiment of the present invention.

Another embodiment of the present invention involves the use of ONO (oxide-nitride-oxide) dielectric stacks in a semiconductor device. ONO stacks are sometimes used as gate dielectrics between a floating gate and a control gate of a nonvolatile memory device. An example of this application is illustrated in FIGs. 4-6, which illustrate in cross-section a portion of a semiconductor device 40. Device 40 includes a semiconductor substrate (for example a silicon wafer) having a logic portion 44 and an memory portion 46. The logic portion and memory portion are separated from one another by an isolation region 48, which may be conventional field oxide isolation or trench oxide isolation. As illustrated in FIG. 4, a thin gate oxide layer 50 (about 85Å) is grown over both the memory and logic portions of the substrate. Then, a polysilicon floating gate electrode is formed over the gate oxide layer within memory portion 46. Next, an ONO dielectric stack having a bottom silicon dioxide layer 54, a silicon nitride layer 56, and a top silicon dioxide layer 58 is formed. Bottom silicon dioxide layer 54 is thermally grown by oxidation of silicon and/or polysilicon to a thickness of about 220Å over polysilicon floating gate electrode 52. Due to the presence of gate oxide layer 50 elsewhere in device 40, additional oxidation of these areas will be much less; therefore, bottom oxide layer 54 is only illustrated over the gate electrode. Silicon nitride layer 56 is then deposited using conventional CVD to a thickness of about 150Å across the entire device, as illustrated in FIG. 4. Top silicon dioxide layer 58 is formed by oxidizing the silicon nitride layer to produce a very thin oxide layer of about 30Å.

ONO dielectric stacks, such as that described above, are often used to separate floating gates from control gates in non-volatile memory devices due to a favorable ability of such a dielectric stack to retain charge. However, the stack is not used in logic portions of devices, and therefore is usually removed. To remove the ONO from logic portion 44, a resist mask 60, for instance a photoresist mask, is formed over the memory portion of device 40, and unmasked portions of the ONO (or ON) stack in the logic portion are removed by etching. A problem in removing the ONO (or ON) is the possibility of damaging the underlying substrate. For instance, in reference to FIG. 4, in removing silicon nitride layer 56 over logic portion 44, one could use a dry etch which is selective to silicon dioxide to stop on gate oxide layer 50. However, as discussed above, known dry etches which are selective to silicon dioxide are not selective to silicon, such that damage or defects in gate oxide layer 50 could lead to pitting of the underlying substrate. Such damage to the substrate is undesirable since it adversely affects the integrity of subsequently grown oxide layers. One could instead use a dry etch selective only to silicon so that silicon nitride layer 56 and gate oxide layer 50 are simultaneously removed over logic portion 44; however, this too will lead to some degree of damage to the substrate despite the selectivity to silicon since the etch is a dry etch. A known method to overcome this problem is to form a thicker sacrificial oxide layer (e.g. 400Å) in the logic portion of the device than in the memory device so that in removing the ONO (or ON) in the logic areas using a plasma etch selective to silicon, there is a much reduced chance of punching through the thicker sacrificial oxide layer and damaging the silicon. Instead, the plasma etch is terminated about halfway through the sacrificial oxide layer, and a wet etch is used to etch the remaining half of the sacrificial oxide layer without damaging the silicon. A true gate oxide (as opposed to the thick sacrificial oxide) is then grown over the logic portion. As is evident, such a solution to the problem involves the additional steps of having to grow two different initial oxide layers of different thicknesses in the logic and memory portions of the device.

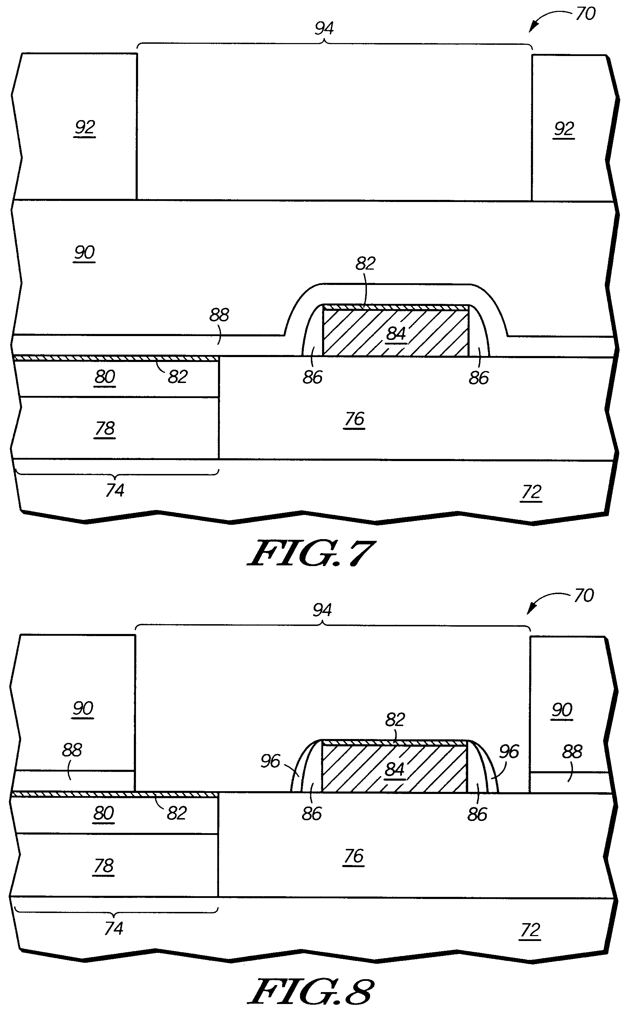

With the present invention, the additional steps discussed above are not necessary. As illustrated in FIG. 4, a thin gate oxide layer 50 of uniform thickness can be formed over both logic and memory portions of the device. In accordance with the present invention, top oxide layer 58 and silicon nitride layer 56 are removed from unmasked portions of the device 40 over logic portion 44 using the inventive etch method described previously. Although the etch is selective to oxide, top oxide layer 58 is thin enough (about 30Å) so that the etch will remove the layer. However, the etch is selective enough so that silicon nitride layer 56 can be removed selectively to gate oxide layer 50, as illustrated in FIG. 5. Furthermore, since the etch is also selective to silicon, there is no threat of damaging underlying substrate 42 in logic portion 44 even though gate oxide layer 50 may be damaged or have defects therein.

FIG. 6 illustrates how processing of device 40 may proceed after the ONO (or ON) stack is removed from the logic portion of the device. A thicker true gate oxide layer is needed in the logic portion of the device than in the memory portion of the device; therefore, a thermal oxidation step is used to grow a gate oxide layer 62 to about 350Å. This is preferably accomplished by first stripping gate oxide layer 50 from above logic portion 44 using a conventional wet etch, and growing a new gate oxide layer 62. A second polysilicon layer is then deposited and patterned to form a gate electrode 64 within logic portion 44 and a control gate electrode 66 overlying floating gate electrode 52 within memory portion 46. The ONO dielectric stack separates floating gate electrode 52 from control gate electrode for enhanced charge storage capability.

Another application in which the present invention is useful is in the formation of local interconnects in semiconductor devices. FIGs. 7-9 illustrate in cross-section a portion of a semiconductor device 70 in which a local interconnect is formed in accordance with the present invention. As illustrated in FIG. 7, device 70 includes a semiconductor substrate 72 having an active region 74 and an isolation region 76. Isolation region 76 is preferably a trench isolation region formed of silicon dioxide in accordance with conventional trench isolation methods, although it may instead be formed as a conventional field oxide. Active region 74 includes an N-well 78 having a P+ doped region 80 formed therein. Alternatively, an N+ doped region may be formed in a P-well in active region 74. Doped region 80 may also include a silicide region 82, for example, a titanium silicide layer, over the doped region.

Formed over isolation region 76 is a polysilicon line 84. Elsewhere in device 70, polysilicon line is likely to be a gate electrode of a transistor; however, it is often necessary to connect such an electrode to other portions of the device, in which case the polysilicon line may be routed across isolation regions. Often, it is desirable to electrically connect the routed polysilicon line to a portion of the active region. One method of achieving this connection is through use of a local interconnect. A known method for forming a local interconnect in this situation involves depositing a dielectric layer, such as PSG (phospho-silicate glass) or BPSG (boron-doped phospho-silicate glass), over the device and etching a hole in the dielectric layer which exposes both the polysilicon line and portions of the active region to be connected. A problem in accomplishing this etch is that it is difficult to etch PSG or BPSG selectively to underlying isolation region 76 since both may be comprised of silicon dioxide. As a result, in removing the dielectric layer, it is likely that isolation region 76 would be overetched or recessed, thereby causing leakage problems in any devices formed within the active region.

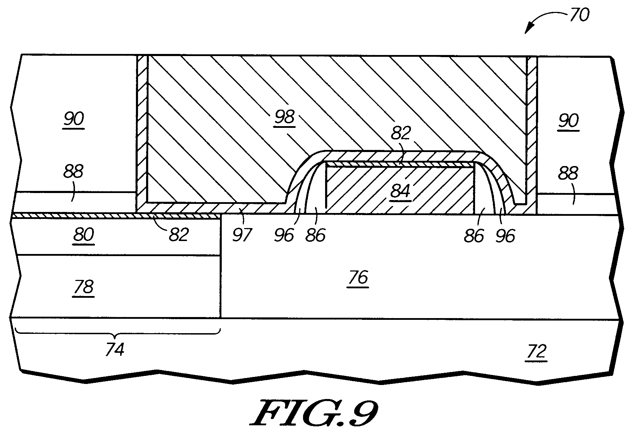

The present invention overcomes such leakage problems by employing an etch which is selective to both silicon dioxide and silicon in conjunction with using a silicon nitride etch mask. As illustrated in FIG. 7, and in accordance with the present invention, polysilicon line 84 is routed over isolation region 76. Adjacent sidewalls of polysilicon line 84 are optional sidewall spacers 86. The polysilicon line may optionally include a silicide region 82 as well. A layer of silicon nitride is then deposited over device 70, including over active region 74, isolation region 76, and polysilicon line 84. In a preferred embodiment of the present invention, silicon nitride layer 88 is deposited using a plasma-enhanced chemical vapor deposition (PECVD) process such as those known in the art. Next a dielectric layer 90 is deposited over silicon nitride layer 88. Dielectric layer 90 may be BPSG, PSG, TEOS (tetra-ethyl-ortho-silicate), a SOG (spin-on-glass), or a similar dielectric material. A resist mask 92, for example a photoresist mask, is formed over dielectric layer 90 such that an opening 94 in the resist mask defines the appropriate area where a local interconnect is to be formed. Once a patterned resist mask is in place, dielectric layer 90 is etched selectively to silicon nitride layer 88 within opening 94. This may be accomplished using any of several known methods in the industry to etch silicon dioxide or similar material selectively to silicon nitride, for example by dry etching used CHF₃ and argon. As a result of this etch, dielectric layer 90 within opening 94 is removed; however, silicon nitride layer 88 remains intact within opening 94. At this point, exposed portions of silicon nitride layer 88 within opening 94 are etched by the inventive etch process described above to expose doped region 80 and polysilicon line 84 (or silicide regions 82 if present), as illustrated in FIG. 8. The silicon nitride layer is etched in accordance with the present invention in an anisotropic manner and such that the silicon nitride is etched selectively to both silicon dioxide (isolation region 76) and silicon (doped region 80, polysilicon line 84, silicide regions 82). Because the etch is anisotropic, residual sidewall spacers 96 of silicon nitride may be formed adjacent to sides of polysilicon line 84 or along sidewall spacers 86 if present. In prior art processes used to form local interconnect structures similar to that illustrated in FIG. 7, etches used to remove a silicon nitride layer often resulted in an overetch in either the silicon dioxide material used to form isolation region 76 or in silicon within the active region 74. However, with the present invention, the silicon nitride layer 88 can be removed selectively to both these regions, thereby minimizing the possibility of junction leakage. Once the active region and polysilicon member overlying the isolation region are exposed, as illustrated in FIG. 8, a glue layer 97 if formed along the sidewalls and bottom of opening 94. Glue layer 97, illustrated in FIG. 9, is used to promote adhesion between dielectric layer 90 and a subsequently deposited conductive material. The conductive material is deposited to fill opening 94, thereby electrically connecting polysilicon line 84 and doped region 80. As an example, a layer of tungsten may be deposited across device 70 and subsequently etched or polished back to form a local interconnect 98, as illustrated in FIG. 9. In the case of using tungsten, a suitable glue layer 97 includes a combination of titanium and titanium nitride to promote adhesion of the tungsten to the adjacent dielectric layer. Rather than using a conductive material to electrically connect a polysilicon line to the active region, the conductive material could instead be used to simply make a contact to the active region. For example, opening 94 may be patterned only over active region 74 and a portion of isolation region 76, without encompassing another conductive member, such as polysilicon line 84.

The foregoing description and illustrations contained herein demonstrate many of the advantages associated with the present invention. A method for etching silicon nitride using CF₄, O₂, and an inert gas, such as argon, etches silicon nitride anisotropically, while at the same time etches selectively to underlying silicon dioxide and silicon materials. As previously described, such an etching method is useful in a variety of applications in manufacturing semiconductor devices, including forming silicon nitride sidewall spacers overlying a thin oxide layer, removing an ONO dielectric stack over a thin oxide to avoid damage to the underlying substrate, and forming a local interconnect or a contact between an active region and a conductive member overlying a dielectric isolation region. While only these three specific applications have been illustrated and described herein, it is anticipated that other applications of the present invention will become apparent given the widespread use of silicon nitride in semiconductor devices. In addition to the many applications of using the present invention, a further advantage is that the present invention is easily implementable in a manufacturing environment since suitable plasma etch systems and gases used are readily available. Moreover, incorporation of a method in accordance with the present invention into a manufacturing process has an advantage of eliminating many existing process steps which are otherwise required to overcome problems that prior art methods have relating to poor selectivity and the isotropic nature of these methods when etching silicon nitride.

Thus, it is apparent that there has been provided in accordance with the invention a method for etching silicon nitride that fully meets the need and advantages set forth above. Although the invention has been described and illustrated with reference to specific embodiments thereof, it is not intended that the invention be limited to these illustrative embodiments. Those skilled in the art will recognize that modifications and variations can be made without departing from the spirit of the invention. For example, the present invention is suitable for etching any type of silicon nitride material, including silicon nitride layers which are deposited using standard chemical vapor deposition (CVD) or plasma-enhanced chemical vapor deposition (PECVD). It is also noted that the present invention can be used to etch silicon nitride selectively to a variety of materials comprising silicon, including but not limited to, single crystal silicon, polysilicon, amorphous silicon, silicides, and dielectric materials comprising silicon dioxide which may be formed or deposited in a variety of ways. Also, it is noted that while argon is a preferred inert gas for use in accordance with the present invention that other inert gases such as nitrogen, helium, xenon, or the like may be suitable alternative. Therefore it is intended that this invention encompass all such variations and modifications as fall with the scope of the appended claims.

## Claims

1. A method of etching silicon nitride, comprising the steps of:
providing a material selected from a group of materials consisting of single crystal silicon, polysilicon, amorphous silicon, silicides, and silicon dioxide;
forming a layer of silicon nitride such that a portion of the layer of silicon nitride is on the material; and
anisotropically etching the portion of the layer of silicon nitride selectively to the material;
wherein the step of anisotropically etching is performed using a plasma etch system and using a CF₄ gas, an O₂ gas, and an inert gas.

2. A method of etching silicon nitride in a semiconductor device, comprising the steps of:
providing a semiconductor substrate comprised of silicon;
forming a polysilicon member over the semiconductor substrate, the polysilicon member having a sidewall;
forming a layer of silicon nitride over the semiconductor substrate and the polysilicon member such that the layer of silicon nitride is present along the sidewall of the polysilicon member; and
anisotropically etching the layer of silicon nitride without etching the semiconductor substrate to form a sidewall spacer adjacent the sidewall of the polysilicon member;
wherein the step of anisotropically etching is performed using a plasma etch system and a CF₄ gas, an O₂ gas, and an inert gas.

3. The method of claim 2 further comprising the step of forming an oxide layer over the semiconductor substrate, and wherein the step of forming a polysilicon member comprises forming a polysilicon member on the oxide layer, wherein the step of forming a layer of silicon nitride comprises forming a layer of silicon nitride on the oxide layer, and wherein the step of anisotropically etching comprises anisotropically etching the layer of silicon nitride selectively to the oxide layer.

4. A method of etching silicon nitride in a semiconductor device, comprising the steps of:
providing a semiconductor substrate;
forming a floating gate electrode over the semiconductor substrate;
forming a dielectric stack of an oxide layer and a silicon nitride layer over the floating gate electrode and over the semiconductor substrate;
masking a portion of the dielectric stack over the floating gate electrode with a resist mask to create a masked portion and an unmasked portion of the dielectric stack; and
removing the dielectric stack in the unmasked portion of the dielectric stack;
wherein the step of removing comprises anisotropically etching the silicon nitride layer without etching the semiconductor substrate by plasma etching using a CF₄ gas, an O₂ gas, and an inert gas.

5. The method of claim 4 further comprising the step of forming a gate oxide layer over the semiconductor substrate, and wherein the step of forming a dielectric stack comprises forming the silicon nitride layer of the dielectric stack over the gate oxide layer, and wherein the step of removing the dielectric stack comprises anisotropically etching the silicon nitride layer selectively to the gate oxide layer.

6. A method of etching silicon nitride in a semiconductor device, comprising the steps of:
providing a semiconductor substrate having an active region and an isolation region abutting the active region;
forming a layer of silicon nitride over the active region and the isolation region;
forming a dielectric layer over the layer of silicon nitride, the active region, and the isolation region;
patterning an opening in the dielectric layer, the opening overlying a portion of the active region and a portion of the isolation region and exposing a portion of the layer of silicon nitride; and
anisotropically etching the portion of the layer of silicon nitride exposed by the opening selectively to the portion of the active region and the portion of the isolation region;
wherein the step of anisotropically etching comprises plasma etching the layer of silicon nitride using a CF₄ gas, an O₂ gas, and an inert gas.

7. The method of claims 1, 2, 4, or 6 wherein the step of anisotropically etching is performed using argon as the inert gas.

8. The method of claim 1, 2, 4, or 6 wherein the step of anisotropically etching comprises using a plasma etch system having an etch chamber, and wherein a plasma is generated in the etch chamber.

9. The method of claims 1, 2, 4, or 6 wherein the step of anisotropically etching comprises etching in a magnetically enhanced plasma etch system.

10. The method of claims 1, 2, 4, or 6 wherein the step of anisotropically etching is performed with a resist mask in place.
